# EUROPEAN PATENT SPECIFICATION

(11) **EP 2 583 867 B1**
(45) Date of publication and mention of the grant of the patent: **02.10.2019**
(21) Application number: 10853261.5
(22) Date of filing: 18.06.2010
(51) Int. Cl.: B60L 50/50

(54) **DETERIORATION DEGREE DETERMINATION DEVICE**
VORRICHTUNG ZUR BESTIMMUNG EINES ZERSETZUNGSGRADES
DISPOSITIF DE DÉTERMINATION DE DEGRÉ DE DÉTÉRIORATION

(43) Date of publication of application: 24.04.2013
(73) Proprietor: TOYOTA JIDOSHA KABUSHIKI KAISHA, Toyota-shi, Aichi-ken, 471-8571 (JP)
(72) Inventor: ISHIKAWA, Tomoyasu, Toyota-shi Aichi 471-8571 (JP); TANAKA, Keiichi, Toyota-shi Aichi 471-8571 (JP)
(74) Representative: TBK
(86) International application number: PCT/JP2010/060400
(87) International publication number: WO 2011/158381

(56) References cited:
- JP-A- 2010 060 408
- JP-A- 2010 112 916
- US-A1- 2004 232 884
- US-A1- 2007 194 761
- US-A1- 2008 223 842
- US-A1- 2010 052 617

## Description

### TECHNICAL FIELD

The present invention relates to a deterioration degree determining apparatus.

### BACKGROUND ART

There has been a battery capacity detecting apparatus including a power-supply part from which electric power is output, a chargeable battery, a charge circuit which charges the battery, a discharge circuit which supplies the electric power of the battery to an electric load, and a charging characteristics storing part which stores charging characteristics related to charge time from a middle discharge state to a full charge state. The battery capacity detecting apparatus further includes a charge controller which charges the battery after bringing the battery to the middle discharge state by turning on and off the charge circuit and the discharge circuit, a time measuring part which measures charge time of the battery, and a full charge capacity detecting part which detects a full charge capacity of the battery based on the charge time and the charging characteristics. The battery capacity detecting apparatus detects deterioration degree of the battery based on the charge time from the middle discharge state to the full charge state and the charge characteristics (see, e.g., Patent Document 1).

[Patent Document 1] Japanese Patent

Application Publication No. 2005-265801

Document US2010052617 discloses a method for detecting a degradation state of a lithium-ion battery.

### DISCLOSURE OF INVENTION

### PROBLEM TO BE SOLVED BY THE INVENTION

When the conventional battery capacity detecting apparatus charges the battery in order to detect the deterioration degree of the battery, an AC adapter of the battery capacity detecting apparatus is connected to an external power source, and the battery capacity detecting apparatus receives electric power from the external power source located outside of a vehicle.

Therefore, the battery capacity detecting apparatus cannot charge the battery without connecting the AC adapter to the external power source in a state where the vehicle is stopped. The battery capacity detecting apparatus detects the deterioration degree of the battery when the vehicle is stopped. Accordingly, it is not possible for the conventional battery capacity detecting apparatus to detect the deterioration degree while the vehicle is being used (while the vehicle is in an idling state or is being driven).

The battery deteriorates depending on a status of use, and the capacity of the battery is decreased. The performance of the battery may be decreased suddenly due to the deterioration. If the deterioration degree can be detected while the vehicle is being used, convenience of the vehicle is highly enhanced. Further, the likelihood of suppressing a failure caused by the deterioration of the battery is highly increased, and reliability of the vehicle is improved.

It is an object of embodiments of the present invention to provide a deterioration degree determining apparatus which can determine a deterioration degree of a battery while the vehicle is being used.

### MEANS FOR SOLVING THE PROBLEMS

In a first aspect of the present invention, a deterioration degree determining apparatus configured to determine a deterioration degree of a battery of a vehicle includes an electric component activating part configured to activate a non-driving series electric component of the vehicle by using electric power of the battery in order to determine the deterioration degree of the battery, a charge degree obtaining part configured to obtain a charge degree of the battery during a period of time in which a charge state of the battery is increased to a designated degree by charging the battery after the battery is discharged for a designated period of time by causing the electric component activating part to activate the non-driving series electric component, the battery being charged by electric power generated by an electric generator of the vehicle, and a deterioration degree determining part configured to determine the deterioration degree of the battery based on the charge degree obtained by the charge degree obtaining part.

### EFFECTS OF THE INVENTION

In accordance with the present invention, it is possible to provide a deterioration degree determining apparatus which can determine a deterioration degree of a battery while the vehicle is being used.

### BRIEF DESCRIPTION OF THE DRAWINGS

FIG. 1 is a diagram illustrating a configuration of a deterioration degree determining apparatus of a first embodiment;
FIG. 2A is a diagram illustrating a circuit which changes electric power pathways of a vehicle on which an on-board unit is mounted;
FIG. 2B is a diagram illustrating a circuit in a state where the electric power pathways are changed in order to determine a deterioration degree of a battery;
FIG. 3 is a diagram for explaining a method for detecting a charge degree of the battery;
FIG. 4A is a flowchart illustrating a process executed by the deterioration degree determining apparatus according to the first embodiment;
FIG. 4B is a flowchart illustrating a process executed by the on-board unit mounted on the vehicle monitored by the deterioration degree determining apparatus;
FIG. 5 is a diagram illustrating a configuration of a deterioration degree determining apparatus of a second embodiment;
FIG. 6 is a flowchart illustrating a process executed by the deterioration degree determining apparatus according to the second embodiment;
FIG. 7 is a diagram illustrating a configuration of a deterioration degree determining apparatus of a third embodiment;
FIG. 8A is a flowchart illustrating processes executed by the deterioration degree determining apparatus according to the third embodiment; and
FIG. 8B is a flowchart illustrating a process executed by a on-board unit mounted on the vehicle monitored by the deterioration degree determining apparatus of the third embodiment.

### DESCRIPTION OF REFERENCE NUMERALS

- 100: Deterioration degree determining apparatus
- 110: Main controller
- 120: Communication part
- 130: Determination command generating part
- 140: Charge degree obtaining part
- 150: Deterioration degree determining part
- 160: DB
- 200: On-board unit
- 210: Main controller
- 220: Communication part
- 230: Idling state determining part
- 240: Traffic information obtaining part
- 250: Continuation determining part
- 260: Electric power pathway controller
- 270: Activation command outputting part
- 280: Charge degree detector
- 290: Monitor
- 10: Vehicle
- 11: Battery
- 12: Alternator
- 13: Non-driving series electric component
- 14: Driving series electric component
- 21, 22, 23, 24: Relay
- 300: Deterioration degree determining apparatus
- 310: Main controller
- 320: Idling state determining part
- 330: Traffic information obtaining part
- 340: Continuation determining part
- 350: Electric component activating part
- 360: Electric power pathway controller
- 370: Charge degree obtaining part
- 380: Deterioration degree determining part
- 390: Monitor
- 400: Deterioration degree determining apparatus
- 401: Traffic information obtaining part
- 500: On-board unit
- 501: Position data obtaining part

### BEST MODE FOR CARRYING OUT THE INVENTION

In the following, embodiments to which a deterioration degree determining apparatus of the present invention is applied will be described.

### <FIRST EMBODIMENT>

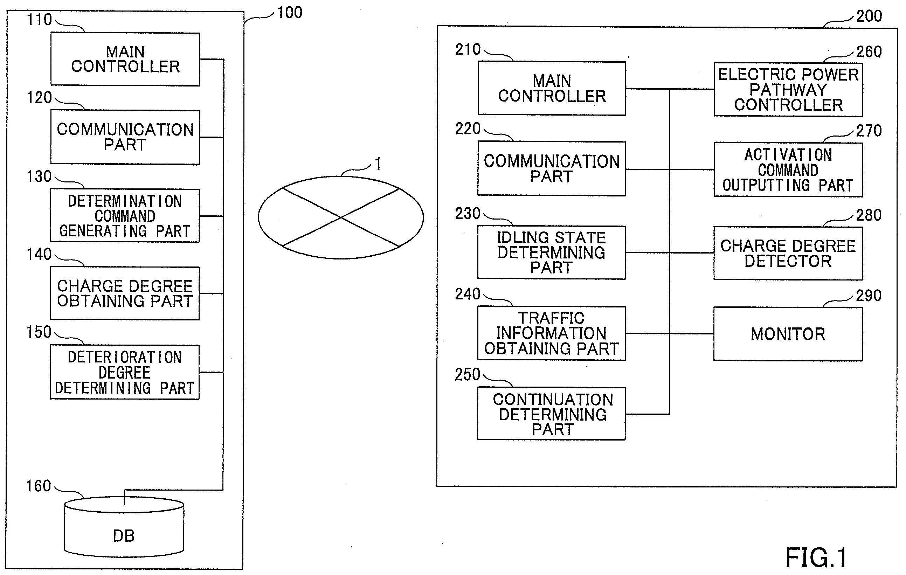

FIG. 1 is a diagram illustrating a configuration of a deterioration degree determining apparatus of the first embodiment.

A deterioration degree determining apparatus 100 according to the first embodiment is a remote monitoring center which monitors vehicles remotely. The deterioration degree determining apparatus 100 includes a main controller 110, a communication part 120, a determination command generating part 130, a charge degree obtaining part 140, a deterioration degree determining part 150 and a database (DB) 160. The deterioration degree determining apparatus 100 is realized by an arithmetic processing apparatus such as a server, for example.

The main controller 110 is a type of a controller which supervises processing performed in the deterioration degree determining apparatus 100, and is realized by a central processing unit (CPU), for example.

The communication part 120 is disposed in the deterioration degree determining apparatus 100 in order to perform data communications with an apparatus mounted on a vehicle which will be described later. The communication part 120 is realized by a modem which performs communication via cellular phone infrastructure, for example.

The determination command generating part 130 generates a determination command which is used for executing a determining process of the deterioration degree of a battery mounted on the vehicle. The determination command generating part 130 is realized by a CPU, for example.

The determination command generated by the determination command generating part 130 is a type of a command which causes a non-driving series electric component of the vehicle to forcibly activate in order to determine the deterioration degree of a battery of the vehicle. The determination command generating part 130 functions as an electric component activating part. An air conditioner, an audio or a navigation device falls into the non-driving series electric component category. A definition of the non-driving series electric components will be described later.

Herein, terms "forcibly activate" do not mean an activation of the non-driving series electric component based on an operation of a user of the vehicle, but mean an activation of the non-driving series electric component for determining the deterioration of the battery.

The charge degree obtaining part 140 obtains data indicating the charge degree of the battery detected in the vehicle via the communication part 120. The charge degree obtaining part 140 is realized by a CPU, for example.

The deterioration degree determining part 150 determines the deterioration degree of the battery based on the data which indicates the deterioration degree obtained by the charge degree obtaining part 140. The deterioration degree determining part 150 is realized by a CPU, for example.

The DB 160 is a type of a database which stores determination results of the deterioration degree determining part 150, data which is necessary for a determination process of the deterioration degree, computer programs that are necessary for the determination process and the like. The DB 160 is realized by a hard disk drive, for example.

The main controller 110, the determination command generating part 130, the charge degree obtaining part 140 and the deterioration degree determining part 150 may be realized by different CPUs, respectively. On the other hand, all of these elements or a portion of these elements may be realized by the same CPU or the same multi-core processor.

The deterioration degree determining apparatus 100 may include a random access memory (RAM) or other type of storing medium for temporarily storing data processed in the determination process.

In the following, an on-board unit 200 which is mounted on the vehicle monitored by the deterioration degree determining apparatus 100 will be described.

The on-board unit 200 which is mounted on the vehicle monitored by the deterioration degree determining apparatus 100 according to the first embodiment includes a main controller 210, a communication part 220, an idling state determining part 230, a traffic information obtaining part 240, a continuation determining part 250, an electric power pathway controller 260, an activation command outputting part 270, a charge degree detector 280 and a monitor 290.

The on-board unit 200 is a type of a unit which detects the deterioration degree of the battery of the vehicle under a designated condition, and sends data indicating the deterioration degree of the battery to the deterioration degree determining apparatus 100 as the remote monitoring center when the on-board unit 200 receives a determination command from the deterioration degree determining apparatus 100.

The main controller 210 is a type of a controller which supervises processing performed in the on-board unit 200, and is realized by a central processing unit (CPU), for example.

The communication part 220 is disposed in the on-board unit 200 in order to perform data communications with the deterioration degree determining apparatus 100. The communication part 220 is realized by a modem which performs communication via cellular phone infrastructure, for example. The communication part 220 communicates with the communication part 120 of the deterioration degree determining apparatus 100 via a cellular phone infrastructure 1.

The idling state determining part 230 determines whether the vehicle is in the idling state. Since vehicle speed is zero in the idling state, the idling state determining part 230 may determine whether the vehicle is in the idling state based on the vehicle speed which is sensed by a vehicle speed sensor.

The traffic information obtaining part 240 obtains traffic information around the vehicle. The traffic information obtaining part 240 may be able to obtain vehicle information and communication system (VICS) data in a traveling direction of the vehicle, for example. The traffic information obtaining part 240 may be typically composed of a navigation system or a VICS tuner included in a navigation system, for example.

The continuation determining part 250 determines whether the idling state of the vehicle continues for a designated period of time. According to the first embodiment, in a case where the idling state determining part 230 determines that the vehicle is in the idling state, the continuation determining part 250 determines that the idling state continues for the designated period of time based on the VICS data obtained by the traffic information obtaining part 240, if a length of a traffic jam is greater than or equal to a designated length. On the contrary, the continuation determining part 250 determines that the idling state does not continue for the designated period of time based on the VICS data obtained by the traffic information obtaining part 240, if the length of the traffic jam is not greater than the designated length.

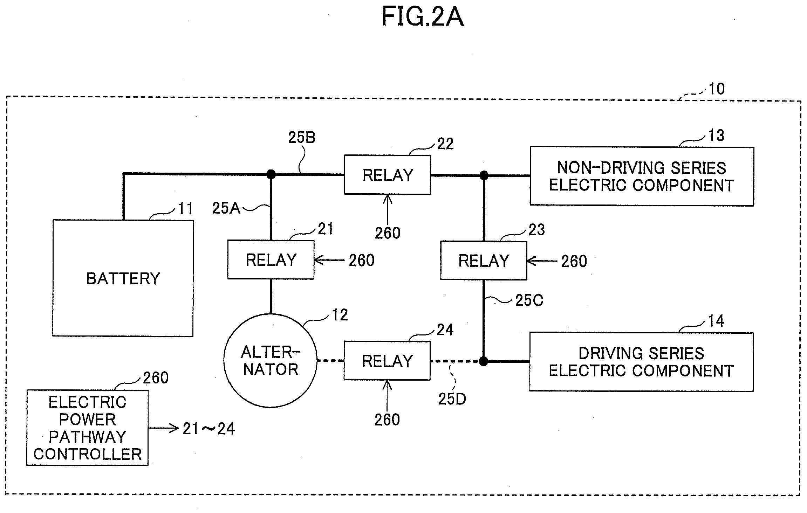

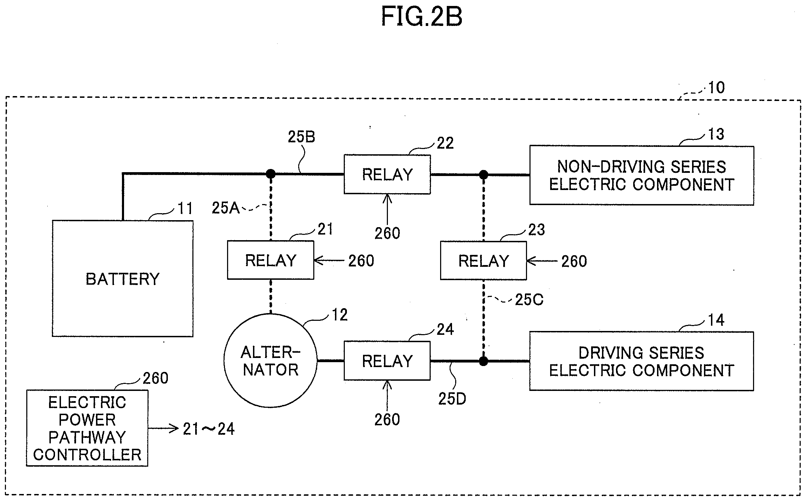

The electric power pathway controller 260 performs change control of electric power pathways among an alternator of the vehicle, the battery, a driving series electric component and the non-driving series electric component in order to detect the deterioration degree of the battery of the vehicle. The change control of the electric power pathways will be described later with reference to FIGS. 2A and 2B.

Herein, electric components that are used for driving of the vehicle such as controllers of an engine or a motor used for driving, an antilock brake system (ABS), an electric power steering device and the like, for example, fall into the driving series electric component category. The non-driving series electric component is an electric component other than the driving series electric component. The air conditioner, the audio, the navigation device and the like, for example, fall into the non-driving series electric component category.

The activation command outputting part 270 outputs an activation command which is used for activating the non-driving series electric component in order to detect the deterioration degree of the battery of the vehicle. For example, in a case where the activation command outputting part 270 activates the air conditioner in order to detect the deterioration degree of the battery, the activation command outputting part 270 outputs the activation command to an electronic control unit (ECU) of the air conditioner.

The charge degree detector 280 detects the charge degree of the battery. Herein, the charge degree is detected during a period of time in which a charge state of the battery is being increased by the electric power generated by the electric generator of the vehicle to a designated degree after discharging the battery for a designated period of time by activating the non-driving series electric component based on the determination command generated by the determination command generating part 130 which functions as the electric component driving part. The charge degree is represented as a period of time required for charging a designated electric power, a time rate of voltage change, a resistance value or the like, for example. The charge state of the battery is represented as an integrated charge amount (a state of charge (SOC)), for example.

The monitor 290 is used for displaying a result of the determination of the deterioration degree of the battery for the user of the vehicle. The monitor 290 may be a monitor of the navigation device, a monitor disposed in a meter panel or the like, for example.

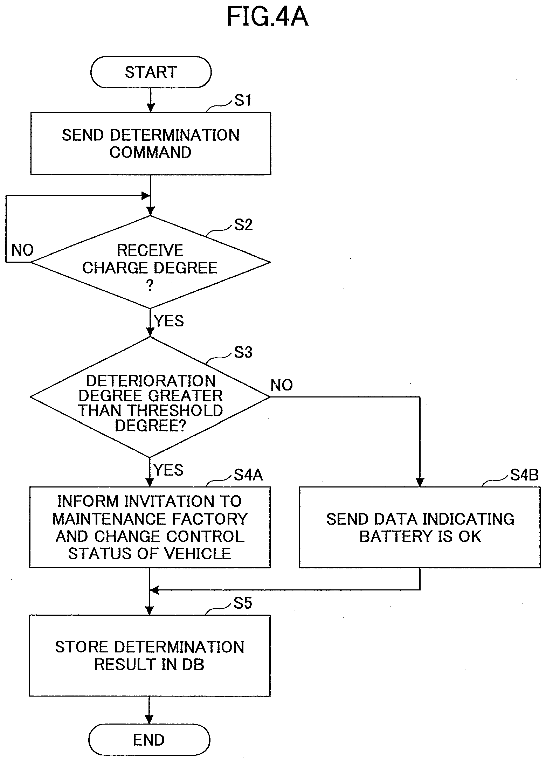

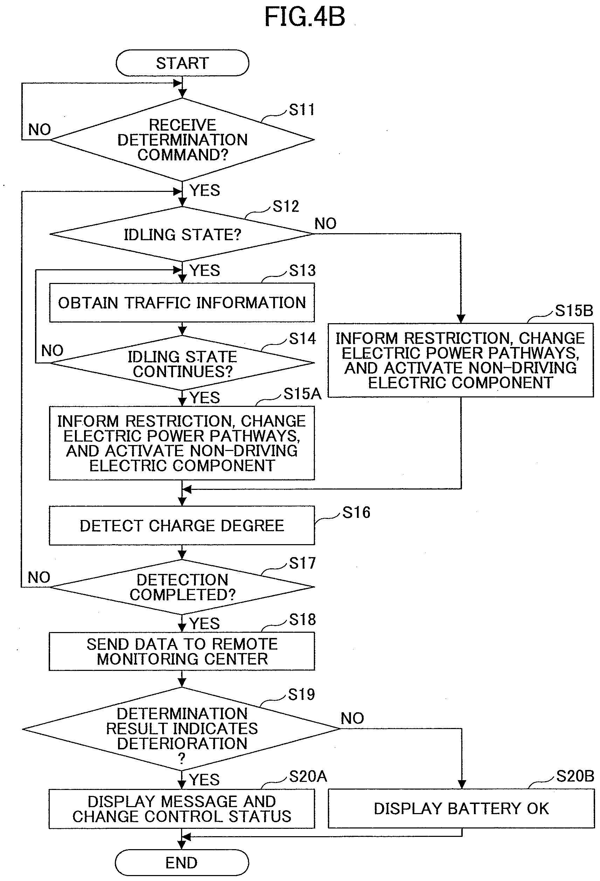

When the on-board unit 200 receives the determination command from the deterioration degree determining apparatus 100, the on-board unit 200 performs a process in which the on-board unit 200 detects the deterioration degree of the battery of the vehicle in the idling state or a driving state, and sends data indicating the deterioration degree of the battery to the deterioration degree determining apparatus 100. The details of the process will be described later with reference to FIGS. 4A and 4B.

In the following, a circuit which changes the electric power pathways will be described.

FIG. 2A is a diagram illustrating the circuit which changes the electric power pathways of the vehicle on which the on-board unit 200 is mounted. FIG. 2B is a diagram illustrating the circuit in a state where the electric power pathways are changed in order to determine the deterioration degree of the battery.

A battery 11 of the vehicle 10 is connected to an alternator 12 which constitutes an electric generator, a non-driving series electric component 13 and a driving series electric component 14. Herein, the alternator 12 generates electric power even in the idling state.

A relay 21 is inserted in series into an electric power pathway 25A which is disposed between the battery 11 and the alternator 12. A relay 22 is inserted in series into an electric power pathway 25B which is disposed between the battery 11 and the non-driving series electric component 13. A relay 23 is inserted in series into an electric power pathway 25C which is disposed between the non-driving series electric component 13 and the driving series electric component 14. The electric power pathway 25C is connected to the battery 11 and the alternator 12 via the electric power pathways 25A and 25B. An electric power pathway 25D which directly connects the alternator 12 and the driving series electric component 14 is disposed in the vehicle 10 according to the first embodiment. A relay 24 is inserted into the electric power pathway 25D.

Change controls of turning on/off the relays 21, 22, 23 and 24 are performed independently by the electric power pathway controller 260. Therefore, the electric power pathway controller 260 of the on-board unit 200 (see FIG. 1) is illustrated in FIGS. 2A and 2B.

In a normal state where the deterioration degree of the battery 11 is not detected, the relays 21, 22 and 23 are turned on, and the relay 24 is turned off. In FIG. 2A, the electric power pathways through which the electric power is transmitted are indicated in solid lines, and the electric power pathways through which the electric power is not transmitted are indicated in dashed line.

In the normal state as illustrated in FIG. 2A, the electric power generated by the alternator 12 is distributed to the battery 11, the non-driving series electric component 13 and the driving series electric component 14. In this case, the battery 11 is charged by the electric power generated by the alternator 12. In a case where power consumptions of the non-driving series electric component 13 and the driving series electric component 14 are relatively large, and the electric power generated by the alternator 12 is insufficient for the non-driving series electric component 13 and the driving series electric component 14, the electric power is supplied to the non-driving series electric component 13 and the driving series electric component 14 from the battery 11 and the alternator 12.

In the first embodiment, the determination of the deterioration degree of the battery 11 is performed based on the charge degree of the battery 11. When the charge degree is being detected, the battery 11 is discharged for the designated period of time by activating the non-driving series electric component 13 based on the determination command generated by the determination command generating part 130 after charging the battery 11, and then a charge amount of the battery 11 is increased to a designated amount by the electric power generated by the alternator 12 of the vehicle 10.

The deterioration degree of the battery 11 is determined based on the charge degree which is detected during a period of time in which the charge amount of the battery 11 is increased to the designated amount.

The reason why the non-driving series electric component 13 is activated in order to discharge the battery 11 is for the sake of consuming the electric power of the battery 11 by activating the non-driving series electric component 13 which does not directly affect a travel motion of the vehicle 10.

In the following, the change controls of the relays 21, 22, 23 and 24 that are performed when the deterioration degree is being detected will be described. The change controls of the relays 21 to 24 are performed in two ways.

In the first stage, the battery 11 is fully charged. In the second stage, the fully charged battery 11 is discharged for the designated period of time by activating the non-driving series electric component 13. Accordingly, a condition of the battery 11 becomes constant regardless of the deterioration degree of the battery 11. The condition of the battery 11 is a concentration of ions or the like that exist around electrodes of the battery 11. It is possible to maintain the concentration constant regardless of the deterioration degree of the battery 11 by discharging a designated constant electric power after fully charging the battery 11.

In the third stage, the battery 11 is charged. In the third stage, the charge degree of the battery 11 is detected.

In the first stage, the battery 11 is charged to a full charge. Herein, the terms "full charge" mean that the charge amount of the battery 11 becomes 100% regardless of the deterioration degree of the battery 11. As the deterioration of the battery 11 progresses, the integrated charge amount (SOC) decreases compared with the battery 11 in a state where the battery 11 is not deteriorated (i.e. in a state where the battery 11 is just shipped from a factory and is brand new) even when the battery 11 is fully charged.

The battery 11 is charged in a state where the relays 21, 22 and 23 are turned on, and the relay 24 is turned off as illustrated in FIG .2A. In the first stage, use of the non-driving series electric component 13 is restricted in order to charge the battery 11 surely.

In the first stage, a message that the use of a part of the functions of the non-driving series electric component 13 is restricted is informed to the driver of the vehicle 10. The restriction of the part of the functions of the non-driving series electric component 13 is realized by turning down the volume of the audio, a part of the functions of the navigation device is restricted or the like, for example. The message that the part of the functions of the non-driving series electric component 13 is restricted is displayed on the monitor 290, for example.

Next, in the second stage, the battery 11 which is fully charged in the first stage is discharged for the designated period of time. Herein, the purpose for discharging the battery for the designated period of time is to maintain the condition of the battery 11 constant regardless of the deterioration degree of the battery 11.

In the second stage, as illustrated in FIG. 2B, the relays 21 and 23 are turned off and the relays 22 and 24 are turned on in order to suppress the battery 11 being charged by the alternator 12, and to supply the electric power to the driving series electric component 14 from the alternator 12.

Next, in the third stage, the battery 11 is charged until the charge amount reaches the designated amount. In the third stage, as illustrated in FIG. 2A, the relays 21, 22 and 23 are turned on, and the relay 24 is turned off, in order to charge the battery 11. Therefore, the battery 11 is connected to the alternator 12 and is charged by the alternator 12. In the third stage, use of the non-driving series electric component 13 is restricted in order to charge the battery 11 surely.

In this time, the message that the use of the part of the functions of the non-driving series electric component 13 is restricted is reported to the driver of the vehicle 10. The restriction of the part of the functions of the non-driving series electric component 13 is realized by turning down the volume of the audio, a part of the functions of the navigation device is restricted or the like, for example. The message that the part of the functions of the non-driving series electric component 13 is restricted is displayed on the monitor 290, for example.

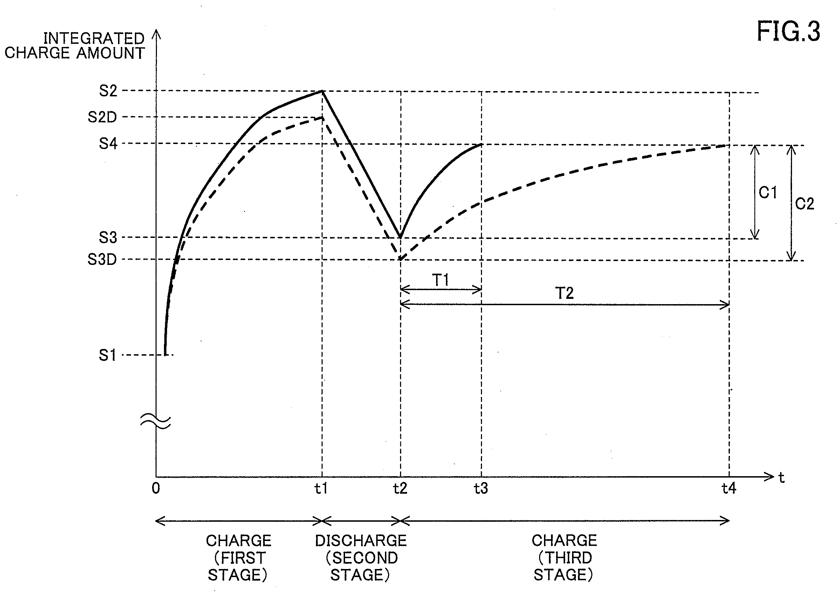

Next, a method for measuring the charge degree performed by the deterioration degree determining apparatus 100 of the first embodiment is described with reference to FIG. 3.

FIG. 3 is a diagram for explaining a method for detecting the charge degree of the battery 11. In FIG. 3, the horizontal axis indicates time, and the vertical axis indicates the integrated charge amount (SOC) representing the charge state.

In the first stage, the battery 11 is fully charged. It is determined that the battery 11 is fully charged when the charge amount becomes 100%. It is possible to determine whether the charge amount becomes 100% or not by measuring the charge amount of the battery 11 by an electric power meter.

In the first stage, as illustrated in FIG. 2A, the relays 21, 22 and 23 are turned on, and the relay 24 is turned off, in order to fully charge the battery 11. Therefore, the battery 11 is connected to the alternator 12 and is charged by the alternator 12. In the first stage, the use of the non-driving series electric component 13 is restricted in order to charge the battery 11 surely.

As indicated by the solid line in FIG. 3, the charge of the brand new battery 11 is started in a state where the integrated charge amount is S1. When the brand new battery 11 is fully charged at time t1, the integrated charge amount rises to S2.

On the contrary, as indicated by the dashed line in FIG. 3, the charge of the deteriorated battery 11 is started in a state where the integrated charge amount is S1. When the deteriorated battery 11 is fully charged at time t1, the integrated charge amount is S2D (<S2).

Next, in the second stage, the battery 11 is discharged for the designated period of time by activating the non-driving series electric component 13 in order to maintain the condition of the battery 11 constant regardless of the deterioration degree of the battery 11.

In the second stage provided from time t1 to time t2, the battery 11 is discharged by activating the non-driving series electric component 13 and thereby consuming the electric power of the battery 11 in a state where the relays 21 and 23 are turned off and the relays 22 and 24 are turned on (see FIG. 2).

During the second stage, the integrated charge amount of the brand new battery 11 falls from S2 to S3 as indicated by the solid line in FIG. 3. During the second stage, the integrated charge amount of the deteriorated battery 11 falls from S2D to S3D (<S3) as indicated by the dashed line in FIG. 3. The time period of the second stage is maintained constant and is provided from time t1 to time t2 regardless whether the battery 11 is brand new or deteriorated.

In the third stage, the battery 11 is charged. In the third stage, the charge degree of the battery 11 is detected.

In the third stage, as illustrated in FIG. 2A, the relays 21, 22 and 23 are turned on, and the relay 24 is turned off, in order to charge the battery 11 in a similar manner to that of the first stage. Therefore, the battery 11 is connected to the alternator 12 and is charged by the alternator 12. In the third stage, use of the non-driving series electric component 13 is restricted in order to charge the battery 11 surely.

The solid line indicated in FIG. 3 represents characteristics of the integrated charge amount (SOC) of the brand new battery 11. It takes a period of time T1 for increasing the integrated charge amount from S3 to S4. The integrated charge amount S4 constitutes the designated charge state. The period of time T1 is provided from time t2 to time t3. The difference between the integrated charge amounts S3 and S4 is a charge amount C1.

On the contrary, as indicated by the dashed line in FIG. 3, it takes a period of time T2 (>T1) in order to charge the deteriorated battery 11 to the designated charge state S4 after the integrated charge amount falls down to S3D. In a case where the battery 11 is deteriorated, it takes more time to charge the battery 11 than in a case where the battery 11 is brand new. The period of time is provided from time t2 to time t4. The difference between the integrated charge amounts S3D and S4 is a charge amount C2. The charge amount C2 is greater than the charge amount C1. The period of time T2 is longer than the period of time T1.

The greater the deterioration of the battery 11 becomes greater (progresses), the longer the period of time which is necessary for the battery 11 to reach the designated charge state S4 becomes.

Thus, the deterioration degree determining apparatus 100 has a threshold charge time and determines that the battery 11 deteriorates to a state where an exchange or an inspection of the battery 11 is necessary, if the charge time of the battery 11 is longer than the threshold charge time. The deterioration degree determining part 150 (see FIG. 1) determines whether the battery 11 has deteriorated or not.

As described above, in the first embodiment, the deterioration degree of the battery 11 is determined by measuring the charge degree, and whether the exchange or the inspection of the battery 11 is necessary or not is determined.

In the following, a process for determining the deterioration degree will be described with reference to FIGS. 4A and 4B.

FIG. 4A is a flowchart illustrating a process executed by the deterioration degree determining apparatus 100 according to the first embodiment.

FIG. 4B is a flowchart illustrating a process executed by the on-board unit 200 mounted on the vehicle 10 monitored by the deterioration degree determining apparatus 100.

As illustrated in FIG. 4A, the deterioration degree determining apparatus 100 sends the determination command to the on-board unit 200 (step S1). The determination command is generated by the determination command generating part 130, and is sent from the deterioration degree determining apparatus 100 to the on-board unit 200 via the communication part 120 by the main controller 110. It is preferable to send the determination command at regular intervals such as once every six months, for example.

Next, the deterioration degree determining apparatus 100 determines whether the deterioration degree determining apparatus 100 receives the data indicating the charge degree from the on-board unit 200 or not (step S2). The main controller 110 receives the data indicating the charge degree via the communication part 120, and then the charge degree obtaining part 140 obtains the data. Herein, the process of step S2 is executed repeatedly until the main controller 110 receives the data indicating the charge degree.

When the deterioration degree determining apparatus 100 receives the data indicating the charge degree from the on-board unit 200 (S2 YES), the deterioration degree determining apparatus 100 determines the deterioration degree of the battery 11 (step S3). The deterioration degree determining part 150 executes the process of the step S3 by comparing the charge time and the threshold charge time based on the data indicating the charge degree obtained by the charge degree obtaining part 140. The determination result is transmitted to the main controller 110 from the deterioration degree determining part 150. The threshold charge time is set to a time longer than the charge time T1 of the brand new battery 11 as illustrated in FIG. 3, and may be set to a time which is 50 percent longer than the charge time T1, for example.

In a case where the deterioration degree determining part 150 determines that the battery 11 is deteriorated, i.e. that the exchange or the inspection is necessary (S3 YES), the main controller 110 sends data which reports an invitation to a maintenance factory and data which is used for changing the control status of the vehicle 10 to the on-board unit 200 (step S4A).

On the other hand, in a case where the deterioration degree determining part 150 determines that the battery 11 is not deteriorated (S3 NO), the main controller 110 sends data which indicates that the battery 11 is not deteriorated to the on-board unit 200 (step S4B).

The main controller 110 stores the determination result in the DB 160 when the process of the step S4A or S4B is finished (step S5). Since the deterioration degree determining apparatus 100 determines the deterioration degrees of the batteries 11 of a lot of the vehicles 10, the determinations results may be stored in the DB 160 as being related to the identifiers of the vehicles 10 and time and date of the determination.

In the following, a process executed by the on-board unit 200 will be described with reference to FIG. 4B.

The on-board unit 200 determines whether the on-board unit 200 receives the determination command from the deterioration degree determining apparatus 100 which constitutes the remote monitoring center (step S11). The process of step S11 is executed repeatedly by the main controller 210 until the main controller 210 receives the determination command.

In a case where the on-board unit 200 receives the determination command (S11 YES), the on-board unit 200 determines whether the vehicle 10 is in the idling state or not (step S12). Since vehicle speed is zero in the idling state, the idling state determining part 230 determines whether the vehicle 10 is in the idling state or not based on the vehicle speed which is sensed by the vehicle speed sensor.

In a case where the on-board unit 200 determines that the vehicle 10 is in the idling state (S12 YES), the on-board unit 200 obtains the traffic information (step S13). Herein, the traffic information obtaining part 240 obtains the VICS data in the travelling direction of the vehicle 10.

Next, the on-board unit 200 determines whether the idling state continues or not (step S14). The process of the step S14 is executed by the continuation determining part 250.

The continuation determining part 250 determines whether the idling state continues or not by determining if the length of the traffic jam is greater than or equal to the designated length or not based on the VICS data obtained by the traffic information obtaining part 240.

In a case where it is determined that the idling state does not continue (S14 NO), the on-board unit 200 returns to step S13. Accordingly, the processes of the steps S13 and S14 are executed repeatedly until the on-board unit 200 determines that the idling state continues.

In a case where it is determined that the idling state continues (S14 YES), the on-board unit 200 reports the restriction of the part of the functions of the non-driving series electric component 13 to the user of the vehicle 10, performs the change control of the electric power pathways, and activates the non-driving series electric component 13 (step S15A).

The main controller 210 displays the message that the part of the functions of the non-driving series electric component 13 is restricted on the monitor 290 in order to report the restriction of the functions to the user of the vehicle 10. The restriction of the part of the functions of the non-driving series electric component 13 is realized by turning down the volume of the audio, a part of the functions of the navigation device is restricted or the like, for example.

The electric power pathway controller 260 executes the change control of the electric power pathways by performing the change control of the relays 21 to 24 (see FIGS. 2A and 2B) in order to detect the charge degree.

The activation command outputting part 270 outputs the activation command in order to activate the non-driving series electric component 13 when the deterioration degree determining apparatus 100 detects the deterioration degree. For example, in a case where the air conditioner is activated in order to detect the deterioration degree, the air conditioner is activated in a designated mode such as a defrost mode, for example, as the activation command outputting part 270 outputs the activation command to the ECU of the air conditioner.

The process of step S15A is executed for measuring the charge degree by reporting the restriction of the part of the functions of the non-driving series electric component 13 to the user of the vehicle 10, by performing the change control of the electric power pathways, and by activating the non-driving series electric component 13.

Since the process of step S15A is executed in the idling state in which the vehicle 10 is stopped, an increased flexibility of activating the non-driving series electric component 13 forcibly is obtained compared with corresponding flexibility obtained at step S15B in which a similar process to the process of step S15A is executed while the vehicle 10 is being driven. Thus, it is possible to perform a quick charge or a quick discharge of the battery 11 at step S15A. Since the vehicle is stopped at step 15A, the main controller 210 of the on-board unit 200 may output the activation command which causes an ECU of a brake system of the vehicle 10 to apply the brakes forcibly.

Next, the on-board unit 200 detects the charge degree (step S16). The process of the step S14 is executed by the charge degree detector 280. The charge degree detector 280 detects the charge degree of the battery 11.

Next, the on-board unit 200 determines whether the detection performed at step S16 is completed or not (step S17).

For example, in a case where the state of the vehicle 10 shifts from the idling state to the driving state during the process of detecting the charge degree at step S15A, the power consumption of the non-driving series electric component 13 or the driving series electric component 14 or the generating capacity of the alternator 12 may vary. Accordingly, the main controller 210 determines that the detection of the charge degree is not completed and returns to the process of step S12 in a case where detecting condition is changed, as in a case where the state of the vehicle shifts from the idling state to the driving state when monitoring the vehicle speed sensed by the vehicle speed sensor, for example.

On the other hand, the main controller 210 determines that the detection of the charge degree is completed in a case where the detecting condition is not changed during the process of detecting the charge degree at step S15A, and goes to step S18.

The on-board unit 200 sends the data indicating the charge degree detected at step S16 to the deterioration degree determining apparatus 100 via the communication part 220 (step S18). The data indicating the charge degree is sent by the main controller 210.

When the on-board unit 200 receives the determination result from the deterioration degree determining apparatus 100, the on-board unit 200 determines whether the determination result indicates the deterioration of the battery 11 or not (step S19). The process of the step S19 is executed by the main controller 210.

If the on-board unit 200 determines that the determination result indicates the deterioration of the battery 11 (S19 YES), the on-board unit 200 displays the message of the invitation to the maintenance factory and executes a change process of a control status of the vehicle 10 (step S20A). In the change process of a control status of the vehicle 10, a part of the functions of the non-driving series electric component 13 is restricted, for example. In a case where the battery 11 is deteriorated, it is preferable to guide the vehicle 10 to a safe place such as the service factory or the like safely and quickly before the battery 11 dies (or is broken). Thus, the load of the battery 11 is reduced by restricting the part of the functions of the non-driving series electric component 13 in order to lengthen a travel distance of the vehicle 10 as much as possible. A restriction of a fan speed of the air conditioner or a volume of the audio falls into the restriction of the non-driving series electric component 13 at step S20A, for example.

On the other hand, in a case where the on-board unit 200 determines that the determination result does not indicate the deterioration of the battery 11 (S19 NO), the on-board unit 200 displays the message that the battery 11 is OK on the monitor 290 (step S20B). In this case, the user of the vehicle 10 can recognize that the exchange or the inspection of the battery 11 is not necessary for a while.

If the on-board unit 200 determines that the vehicle 10 is not in the idling state (S12 NO), the on-board unit 200 goes to step S15B. In a case where the on-board unit 200 determines that the vehicle 10 is not in the idling state, the vehicle speed is not zero and the vehicle 10 is being driven.

The on-board unit 200 executes a process of step S15B in order to detect the status of the battery 11 in the driving state of the vehicle 10. The process of the step S15B is basically the same as that of step S15A.

In a case where the on-board unit 200 determines that the vehicle 10 is in the driving state (S12 NO), the on-board unit 200 reports the restriction of the part of the functions of the non-driving series electric component 13 to the user of the vehicle 10, performs the change control of the electric power pathways, and activates the non-driving series electric component 13 (step S15B).

Since the process of step S15B which is executed when the vehicle 10 is in the driving state is different from the process of step S15A which is executed during the idling state, the contents of the restriction of the part of the functions of the non-driving series electric component 13 or the activation of the non-driving series electric component 13 may be arranged for the driving state, for example. In the driving state of the vehicle 10, the generating capacity of the alternator 12 is increased in association with an increase of the revolution speed of the engine compared with the idling state. Thus, the restriction of the part of the functions of the non-driving series electric component 13 may be loosened, for example.

The non-driving series electric component 13 is activated in the process of step S15B, and the on-board unit 200 goes to step S17 after detecting the charge degree at step S16.

At step S17, the on-board unit 200 determines that the detection of the charge degree is not finished in a case where the detecting condition is changed during the detecting process of the charge degree, as in a case where the state of the vehicle shifts from the idling state to the driving state during the process, for example.

Then the on-board unit 200 executes the processes of steps S18 to S20A or S20B.

The on-board unit 200 finishes the sequence of the processes after finishing the step S20A or S20B.

If the on-board unit 200 determines that the battery 11 is extremely deteriorated, the on-board unit 200 may supply the electric power generated by the alternator 12 to the driving series electric component 14 preferentially, for example. Thus, it is possible to drive the vehicle 10 to the service factory or the like. In this condition, it becomes possible to protect the deteriorated battery 11 by supplying the electric power from the alternator 12 to the battery 11, the non-driving series electric component 13 and the driving series electric component 14 by connecting the battery 11, the alternator 12, the non-driving series electric component 13 and the driving series electric component 14 as illustrated in FIG. 2A. The deteriorated battery 11 may not be rechargeable, if an electric power supply is shut down. It becomes possible to suppress an occurrence of a state where the battery 11 is not rechargeable by controlling the electric power pathways as described above.

According to the deterioration degree determining apparatus 100 of the first embodiment, the non-driving series electric component 13 is activated forcibly while the vehicle 10 is being used (while the vehicle 10 is in the idling state or the driving state) in order to consume the electric power of the battery 11. Since the on-board unit 200 detects the charge degree by utilizing the discharge of the battery 11 which occurs in connection with consumption of electric power and determines the deterioration degree based on the charge degree, it is possible to determine the deterioration degree of the battery 11 while the vehicle 10 is being used.

Thus, it is possible to provide the deterioration degree determining apparatus 100 and the on-board unit 200 that are very convenient. Since the deterioration degree of the battery 11 can be detected while the vehicle 10 is being used, it becomes possible to highly improve a likelihood of suppressing occurrence of the failure caused by the deterioration of the battery 11, and to improve the reliability of the vehicle 10.

Further, since the determination result about the deterioration of the battery 11 is reported to the user of the vehicle 10, it is possible to provide a sense of safety for the user. In this case, if the deterioration degree is determined while the vehicle 10 is being used, and the determination result is reported to the user while the user is using the vehicle 10, it becomes possible to provide a strong sense of safety for the user who is using the vehicle 10.

According to the embodiment as described above, the on-board unit 200 determines whether the idling state continues or not by determining if the length of the traffic jam is greater or equal to the designated length at step S14 based on the traffic information obtained at step S13.

However, the method for determining continuation of traffic jam is not limited to the method as described above, the continuation of the traffic jam may be determined by monitoring running condition of the vehicles existing in front of and behind the vehicle 10 based on picture signals or video signals obtained from cameras provided in the front side and the rear side of the vehicle 10, for example. Charge coupled device (CCD) cameras may be provided on the vehicle 10.

In this case, the deterioration degree determining apparatus 100 as the remote monitoring center may collect the picture signals or the video signals that are sent from the plural vehicles 10, and send traffic information signals indicating existence or non-existence of the traffic jam to the on-board units 200 of the vehicles 10. The on-board units 200 determine the continuation of the traffic jam based on the traffic information signals, respectively.

Although, the embodiment in which the vehicle 10 includes the alternator 12 as the electric generator is described, the deterioration degree determining apparatus 100 and the on-board unit 200 may be applied to a vehicle which uses a motor generator (MG) as the electric generator instead of the alternator 12 or a vehicle which includes an electric generator different from the alternator 12.

A hybrid vehicle (HV) or an electric vehicle (EV) may be fall into the vehicle category as described above.

### <SECOND EMBODIMENT>

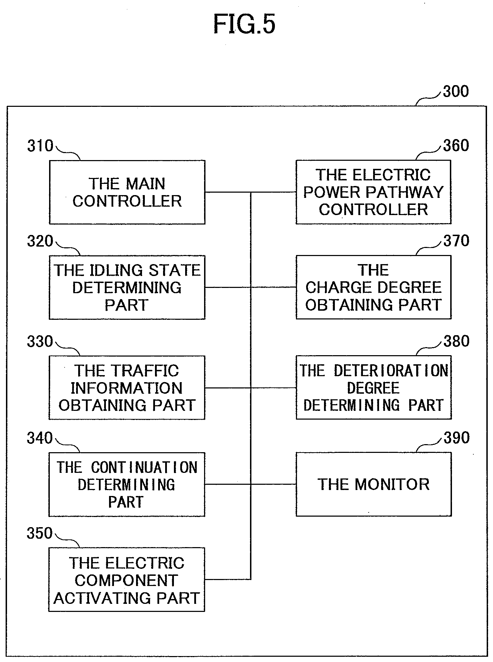

FIG. 5 is a diagram illustrating a configuration of a deterioration degree determining apparatus 300 of the second embodiment.

The deterioration degree determining apparatus 300 according to the second embodiment is mounted on the vehicle 10 (see FIGS. 2A and 2B). Accordingly, the deterioration degree determining apparatus 300 is different from the deterioration degree determining apparatus 100 and the on-board unit 200 of the first embodiment in that the deterioration degree determining apparatus 300 is completed in the vehicle 10.

The deterioration degree determining apparatus 300 includes a main controller 310, an idling state determining part 320, a traffic information obtaining part 330, a continuation determining part 340, an electric component activating part 350, an electric power pathway controller 360, a charge degree obtaining part 370, a deterioration degree determining part 380 and a monitor 390.

The main controller 310 is a type of a controller which supervises processing performed in the deterioration degree determining apparatus 300, and is realized by a CPU, for example.

The idling state determining part 320 determines whether the vehicle is in the idling state. Since vehicle speed is zero in the idling state, the idling state determining part 320 may determine whether the vehicle is in the idling state based on the vehicle speed which is sensed by a vehicle speed sensor.

The traffic information obtaining part 330 obtains the traffic information around the vehicle. The traffic information obtaining part 330 may be able to obtain the VICS data in a traveling direction of the vehicle 10, for example. The traffic information obtaining part 330 may be typically composed of the navigation system or the VICS tuner included in the navigation system, for example.

The continuation determining part 340 determines whether the idling state of the vehicle 10 continues for a designated period of time. According to the second embodiment, in a case where the idling state determining part 320 determines that the vehicle 10 is in the idling state, the continuation determining part 340 determines that the idling state continues for the designated period of time based on the VICS data obtained by the traffic information obtaining part 330, if a length of a traffic jam is greater than or equal to a designated length. On the contrary, the continuation determining part 340 determines that the idling state does not continue for the designated period of time based on the VICS data obtained by the traffic information obtaining part 330, if the length of the traffic jam is not greater than the designated length.

The electric component activating part 350 outputs an activation command used for forcibly activating the non-driving series electric component in order to detect the deterioration degree of the battery 11 of the vehicle 10. For example, in a case where the electric component activating part 350 activates the air conditioner in order to detect the deterioration degree of the battery 11, the electric component activating part 350 outputs the activation command to the ECU of the air conditioner.

The electric power pathway controller 360 performs change control of electric power pathways among the alternator 12 of the vehicle 10, the battery 11, the non-driving series electric component 13 and the driving series electric component 14 in order to detect the deterioration degree of the battery of the vehicle. The change control of electric power pathways is the same with that of the first embodiment as illustrated in FIGS. 2A and 2B.

Herein, electric components that are used for driving of the vehicle such as controllers of the engine or the motor used for driving, the antilock brake system (ABS), the electric power steering device and the like, for example, fall into the driving series electric component 14. The non-driving series electric component 13 is an electric component other than the driving series electric component 14. The air conditioner, the audio, the navigation device and the like, for example, fall into the non-driving series electric component 13.

The charge degree obtaining part 370 obtains the charge degree of the battery 11. Herein, the charge degree is detected during a period of time in which the charge state of the battery 11 is being increased by the electric power generated by the alternator 12 of the vehicle 10 to the designated degree after discharging the battery 11 for the designated period of time by activating the non-driving series electric component 13. The electric component activating part 350 activates electric component driving parts. The charge degree is represented as a period of time required for charging or discharging a designated electric power, a time rate of voltage change, a resistance value or the like, for example.

The deterioration degree determining part 380 determines the deterioration degree of the battery 11 based on the data which indicates the deterioration degree obtained by the charge degree obtaining part 370. The deterioration degree determining part 380 is realized by a CPU, for example.

The monitor 390 may be a monitor of the navigation device, a monitor disposed in a meter panel or the like, for example.

The main controller 310, the continuation determining part 340, the electric component activating part 350, the electric power pathway controller 360 and the deterioration degree determining part 380 may be realized by an ECU used for the deterioration degree determining apparatus 300, for example.

In this case, the idling state determining part 320 may be a vehicle speed sensor, the traffic information obtaining part 330 may be a VICS data obtaining portion attached to the navigation device, the charge degree obtaining part 370 may be a power source ECU, and he monitor 390 may be the monitor of the navigation device, the monitor disposed in the meter panel or the like, as described above.

The ECU used for the deterioration degree determining apparatus 300 including the main controller 310, the continuation determining part 340, the electric component activating part 350, the electric power pathway controller 360 and the deterioration degree determining part 380, the vehicle speed sensor (the idling state determining part 320), the VICS data obtaining portion (the traffic information obtaining part 330), the power source ECU and the monitor 390 may be connected by a controller area network (CAN), for example.

However, the main controller 310, the idling state determining part 320, the traffic information obtaining part 330, the continuation determining part 340, the electric component activating part 350, the electric power pathway controller 360, the charge degree obtaining part 370, the deterioration degree determining part 380 and the monitor 390 are not limited to have the configuration as described above. All the elements 310 to 390 may be realized by a single apparatus (typically an ECU). The elements 310 to 390 may be divided into groups arbitrarily. Each of the groups may be realized by an ECU.

The deterioration degree determining apparatus 300 may include a random access memory (RAM) or other type of storing medium for temporarily storing data processed in the determination process.

The change control of the electric power pathways of the deterioration degree determining apparatus 300 according to the second embodiment is the same as that of the first embodiment other than that the relays 21, 22, 23 and 24 are turned on/off by the electric power pathway controller 360 (see FIG. 5). Thus, FIGS. 2A and 2B are incorporated herein, and the descriptions thereof are omitted.

The method for measuring the charge degree of the deterioration degree determining apparatus 300 is the same as that of the first embodiment. Thus, FIGS 3A and 3B are incorporated herein, and the descriptions thereof are omitted.

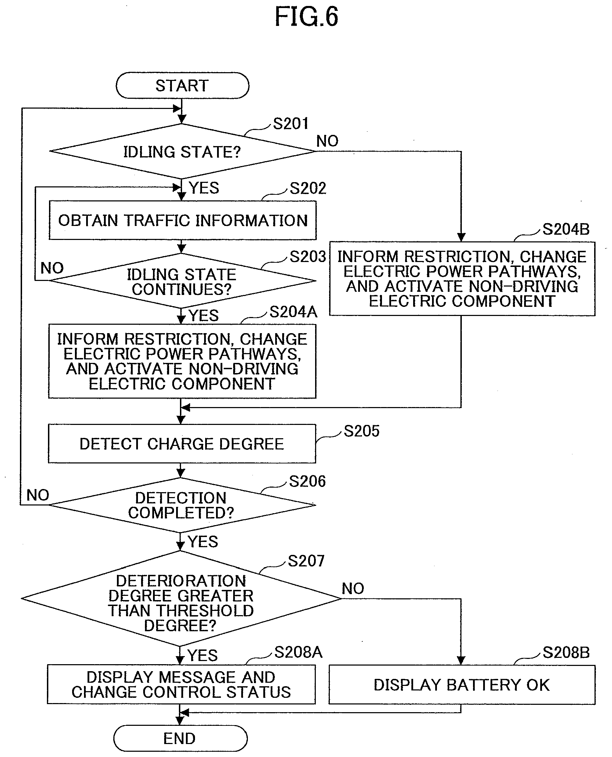

Next, a process for determining the deterioration degree of the battery 11 executed by the deterioration degree determining apparatus 300 according to the second embodiment will be described with reference to FIG. 6.

FIG. 6 is a flowchart illustrating a process executed by the deterioration degree determining apparatus 300 according to the second embodiment. It is preferable to determine the deterioration degree of the deterioration degree determining apparatus 300 at regular intervals such as once every six months, for example.

As illustrated in FIG. 6, the deterioration degree determining apparatus 300 determines whether the vehicle 10 is in the idling state or not (step S201). Since vehicle speed is zero in the idling state, the idling state determining part 320 determines whether the vehicle 10 is in the idling state or not based on the vehicle speed which is sensed by the vehicle speed sensor.

In a case where the deterioration degree determining apparatus 300 determines that the vehicle 10 is in the idling state (S201 YES), the deterioration degree determining apparatus 300 obtains the traffic information (step S202). Herein, the traffic information obtaining part 330 obtains the VICS data in the travelling direction of the vehicle 10.

Next, the deterioration degree determining apparatus 300 determines whether the idling state continues or not (step S203). The process of the step S203 is executed by the continuation determining part 340.

The continuation determining part 340 determines whether the idling state continues or not by determining if the length of the traffic jam is greater than or equal to the designated length or not based on the VICS data obtained by the traffic information obtaining part 330.

In a case where the deterioration degree determining apparatus 300 determines that the idling state does not continue (S203 NO), the deterioration degree determining apparatus 300 returns to step S202. Accordingly, the processes of the steps S203 and S203 are executed repeatedly until the deterioration degree determining apparatus 300 determines that the idling state continues.

In a case where the deterioration degree determining apparatus 300 determines that the idling state continues (S203 YES), the deterioration degree determining apparatus 300 reports the restriction of the part of the functions of the non-driving series electric component 13 to the user of the vehicle 10, performs the change control of the electric power pathways, and activates the non-driving series electric component 13 (step S204A).

The main controller 310 displays the message that the part of the functions of the non-driving series electric component 13 is restricted on the monitor 390 in order to report the restriction of the functions to the user of the vehicle 10. The restriction of the part of the functions of the non-driving series electric component 13 is realized by turning down the volume of the audio, a part of the functions of the navigation device is restricted or the like, for example.

The electric power pathway controller 360 executes the change control of the electric power pathways by performing the change control of the relays 21 to 24 (see FIGS. 2A and 2B) in order to detect the charge degree.

The electric component activating part 350 outputs the activation command in order to activate the non-driving series electric component 13 when the deterioration degree determining apparatus 300 detects the deterioration degree. For example, in a case where the air conditioner is activated in order to detect the deterioration degree, the air conditioner is activated in a designated mode such as a defrost mode, for example, as the electric component activating part 350 outputs the activation command to the ECU of the air conditioner.

The process of step S204A is executed for measuring the charge degree by reporting the restriction of the part of the functions of the non-driving series electric component 13 to the user of the vehicle 10, by performing the change control of the electric power pathways, and by activating the non-driving series electric component 13.

Next, the deterioration degree determining apparatus 300 detects the charge degree (step S205). The process of the step S205 is executed by the charge degree obtaining part 370. The charge degree obtaining part 370 obtains the charge degree of the battery 11.

Next, the deterioration degree determining apparatus 300 determines whether the detection performed at step S205 is completed or not (step S206).

For example, in a case where the state of the vehicle 10 shifts from the idling state to the driving state during the process of detecting the charge degree at step S204A, the power consumption of the non-driving series electric component 13 or the driving series electric component 14 or the generation amount of the alternator 12 may vary. Accordingly, the main controller 310 determines that the detection of the charge degree is not completed and returns to the process of step S201 in a case where detecting condition is changed, as in a case where the state of the vehicle shifts from the idling state to the driving state when monitoring the vehicle speed sensed by the vehicle speed sensor, for example.

On the other hand, the main controller 310 determines that the detection of the charge degree is completed in a case where the detecting condition is not changed during the process of detecting the charge degree at step S204A, and goes to step S207.

The deterioration degree determining apparatus 300 determines that the battery 11 is deteriorated to the state in which the exchange or the inspection is necessary in a case where the charge degree obtained by the charge degree obtaining part 370 is greater than a threshold degree (step S207). The process of the step S207 is executed by the deterioration degree determining part 380.

If the deterioration degree determining apparatus 300 determines that the determination result of the deterioration degree determining part 380 indicates the deterioration of the battery 11 (S207 YES), the deterioration degree determining apparatus 300 displays the message of the invitation to the maintenance factory and executes a change process of a control status of the vehicle 10 (step S208A). In the change process of a control status of the vehicle 10, a part of the functions of the non-driving series electric component 13 is restricted, for example. In a case where the battery 11 is deteriorated, it is preferable to guide the vehicle 10 to a safe place such as the service factory or the like safely and quickly before the battery 11 dies (or is broken). Thus, the load of the battery 11 is reduced by restricting the part of the functions of the non-driving series electric component 13 in order to lengthen a travel distance of the vehicle 10 as much as possible. A restriction of a fan speed of the air conditioner or a volume of the audio falls into the restriction of the non-driving series electric component 13 at step S20A, for example.

On the other hand, in a case where the deterioration degree determining apparatus 300 determines that the determination result does not indicate the deterioration of the battery 11 (S207 NO), the deterioration degree determining apparatus 300 displays the message that the battery 11 is OK on the monitor 390 (step S208B). In this case, the user of the vehicle 10 can recognize that the exchange or the inspection of the battery 11 is not necessary for a while.

If the deterioration degree determining apparatus 300 determines that the vehicle 10 is not in the idling state (S201 NO), the deterioration degree determining apparatus 300 goes to step S204B. In a case where the on-board unit 200 determines that the vehicle 10 is not in the idling state, the vehicle speed is not zero and the vehicle 10 is being driven.

The deterioration degree determining apparatus 300 executes a process of step S204B in order to detect the status of the battery 11 in the driving state of the vehicle 10. The process of the step S204B is basically the same as that of step S204A.

In a case where the deterioration degree determining apparatus 300 determines that the vehicle 10 is in the driving state (S201 NO), the deterioration degree determining apparatus 300 reports the restriction of the part of the functions of the non-driving series electric component 13 to the user of the vehicle 10, performs the change control of the electric power pathways, and activates the non-driving series electric component 13 (step S204B).

Since the process of step S204B which is executed when the vehicle 10 is in the driving state is different from the process of step S204A which is executed during the idling state, the contents of the restriction of the part of the functions of the non-driving series electric component 13 or the activation of the non-driving series electric component 13 may be arranged for the driving state, for example. In the driving state of the vehicle 10, the generating capacity of the alternator 12 is increased in association with an increase of the revolution speed of the engine compared with the idling state. Thus, the restriction of the part of the functions of the non-driving series electric component 13 may be loosened, for example.

The non-driving series electric component 13 is activated in the process of step S204B, and the deterioration degree determining apparatus 300 goes to step S206 after detecting the charge degree at step S205.

At step S206, the deterioration degree determining apparatus 300 determines that the detection of the charge degree is not finished in a case where the detecting condition is changed during the detecting process of the charge degree, as in a case where the state of the vehicle shifts from the idling state to the driving state during the process, for example.

Then the deterioration degree determining apparatus 300 executes the processes of steps S207 and S208A or S208B.

The deterioration degree determining apparatus 300 finishes the sequence of the processes after finishing the step S208A or S208B.

According to the deterioration degree determining apparatus 300 of the second embodiment, the non-driving series electric component 13 is activated forcibly while the vehicle 10 is being used (while the vehicle 10 is in the idling state or the driving state) in order to consume the electric power of the battery 11. Since the deterioration degree determining apparatus 300 detects the charge degree by utilizing the discharge of the battery 11 which occurs in connection with electric power consume and determines the deterioration degree based on the charge degree, it is possible to determine the deterioration degree of the battery 11 while the vehicle 10 is being used.

Thus, it is possible to provide the deterioration degree determining apparatus 300 which is very convenient and can be mounted on the vehicle 10.

Since the deterioration degree of the battery 11 can be detected while the vehicle 10 is being used, it becomes possible to highly improve a likelihood of suppressing occurrence of the failure caused by the deterioration of the battery 11, and to improve the reliability of the vehicle 10.

Further, since the determination result about the deterioration of the battery 11 is reported to the user of the vehicle 10, it is possible to provide a sense of safety for the user. In this case, if the deterioration degree is determined while the vehicle 10 is being used, and the determination result is reported to the user while the user is using the vehicle 10 ,it becomes possible to provide a strong sense of safety for the user who is using the vehicle 10.

### <THIRD EMBODIMENT>

A deterioration degree determining apparatus according to the third embodiment is different from the deterioration degree determining apparatus 100 in that the deterioration degree determining apparatus of the third embodiment determines whether the vehicle is in the traffic jam or not based on position data received from the vehicle, and sends the determination command to the vehicle in the traffic jam.

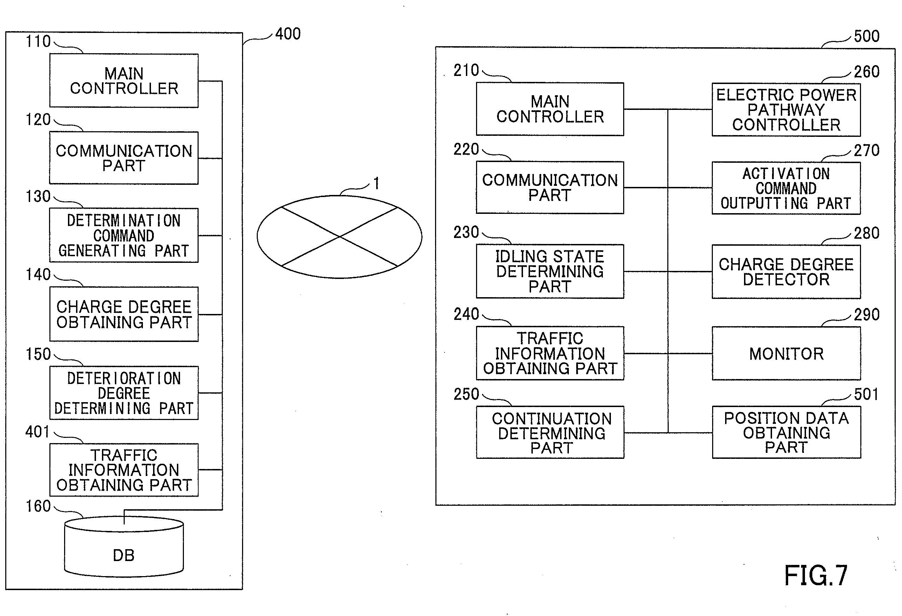

FIG. 7 is a diagram illustrating a configuration of a deterioration degree determining apparatus 400 of the third embodiment.

A deterioration degree determining apparatus 400 according to the third embodiment is a remote monitoring center which monitors vehicles 10 (see FIGS. 2A and 2B) remotely. The deterioration degree determining apparatus 400 includes a main controller 110, a communication part 120, a determination command generating part 130, a charge degree obtaining part 140, a deterioration degree determining part 150, a traffic information obtaining part 401 and a database (DB) 160.

The deterioration degree determining apparatus 400 is basically the same as the deterioration degree determining apparatus 100 other than that the deterioration degree determining apparatus 400 includes the traffic information obtaining part 401. Therefore, descriptions of the main controller 110, the communication part 120, the determination command generating part 130, the charge degree obtaining part 140, the deterioration degree determining part 150 and the DB 160 are omitted.

The traffic information obtaining part 401 is realized by a device which can obtain the VICS data.

The deterioration degree determining apparatus 400 which functions as the remote monitoring center collects probe data including the traffic information and the like from a lot of the vehicles 10. The main controller 110 of the deterioration degree determining apparatus 400 can determine whether each of the vehicles 10 is in the traffic jam or not based on the position data received from the corresponding vehicles 10 and the VICS data obtained by the traffic information obtaining part 401.

An on-board unit 500 of the third embodiment includes a main controller 210, a communication part 220, an idling state determining part 230, a traffic information obtaining part 240, a continuation determining part 250, an electric power pathway controller 260, an activation command outputting part 270, a charge degree detector 280, a monitor 290 and a position data obtaining part 501. The on-board unit 500 of the third embodiment is basically the same as the on-board unit 200 of the first embodiment other than that the on-board unit 500 includes the position data obtaining part 501. Otherwise, the on-board unit 500 according to the third embodiment is similar to the on-board unit 200 of the first embodiment. Therefore, the descriptions of the main controller 210, the communication part 220, the idling state determining part 230, the traffic information obtaining part 240, the continuation determining part 250, the electric power pathway controller 260, the activation command outputting part 270, the charge degree detector 280 and the monitor 290 are omitted.

The position data obtaining part 501 obtains the position data of the vehicle 10. The position data obtaining part 501 may typically be realized by the navigation device.

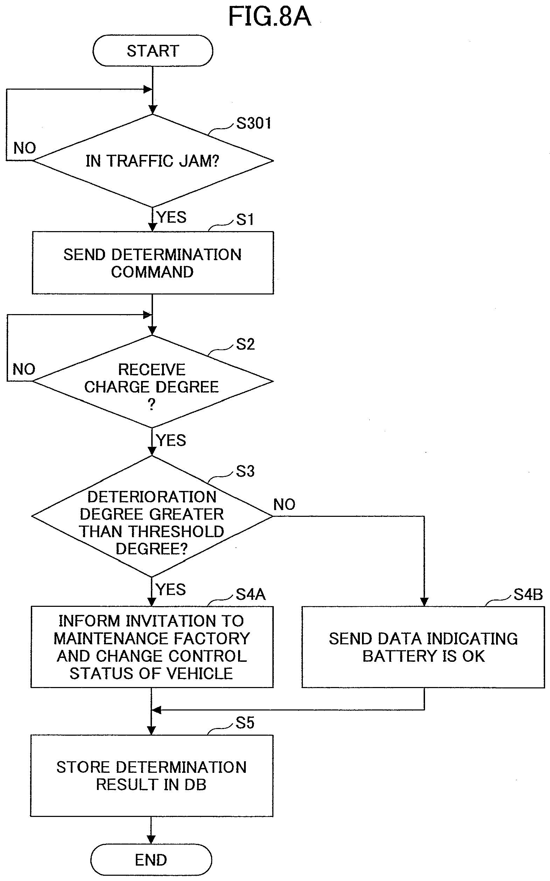

FIG. 8A is a flowchart illustrating processes executed by the deterioration degree determining apparatus 400 according to the third embodiment.

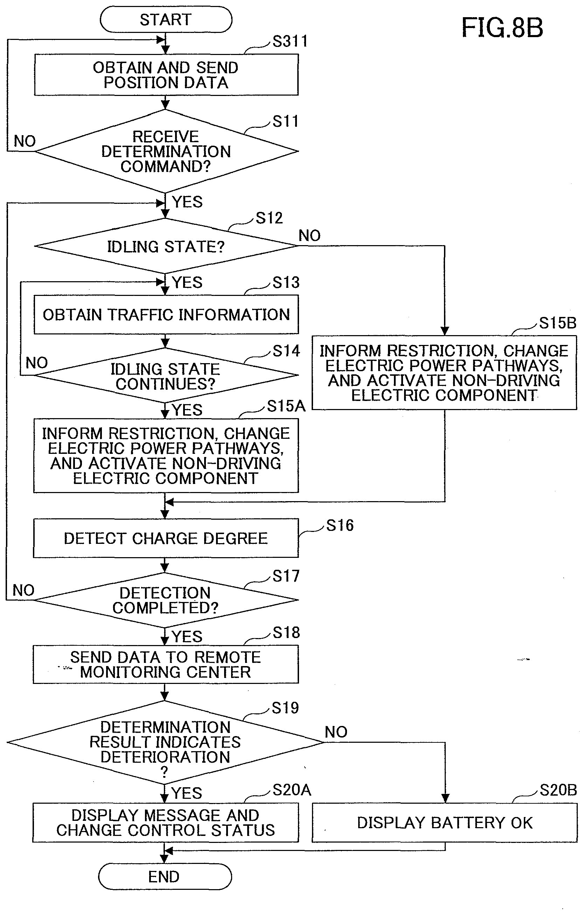

FIG. 8B is a flowchart illustrating a process executed by the on-board unit 500 mounted on the vehicle 10 monitored by the deterioration degree determining apparatus 400 of the third embodiment.

As illustrated in FIG. 8A, the processes of steps S1 to S5 executed by the deterioration degree determining apparatus 400 are the same as the processes of steps S1 to S5 executed by the deterioration degree determining apparatus 100 other than a process of step S301 which is inserted before the process of the step S1. Therefore, the descriptions of the processes of steps S1 to S5 are omitted.

As illustrated in FIG. 8A, when the main controller 110 of the deterioration degree determining apparatus 400 starts the processes, the main controller 110 determines whether the vehicles 10 are in the traffic jams or not based on the position data received from the vehicles 10 and the VICS data obtained by the traffic information obtaining part 401 (step S301). Accordingly, the main controller 110 of the deterioration degree determining apparatus 400 determines whether each of the vehicles 10 is in the traffic jam or not based on the position data received from the correponding vehicles 10 and the VICS data obtained by the traffic information obtaining part 401.

The process of step S301 is executed by the main controller 110 repeatedly until the main controller 110 determines that the vehicles 10 that send the position data are in the traffic jams.

When the deterioration degree determining apparatus 400 determines that the vehicles 10 are in the traffic jams at step S301, the deterioration degree determining apparatus 400 sends the determination command to the vehicles 10 that are determined to be in the traffic jams.

The deterioration degree determining apparatus 400 executes the same processes of steps S2 to S5 as those of the first embodiment after finishing the process of step S1.

As illustrated in FIG. 8B, the processes of steps S11 to S20A and S20B executed by the on-board unit 500 are the same as the processes of steps S11 to S20A and 20B executed by the on-board unit 200 other than a process of step S311 which is inserted before the process of the step S11. Therefore, the descriptions of the processes of steps S11 to S20A and S20B are omitted.

As illustrated in FIG. 8B, when the on-board unit 500 starts the processes, the on-board unit 500 sends the position data obtained by the position data obtaining part 501 to the deterioration degree determining apparatus 400 (step S311).

In the process of the step S311, the main controller 210 sends the position data to the deterioration degree determining apparatus 400 via the communication part 220.

When the on-board unit 500 sends the position data to the deterioration degree determining apparatus 400 at step S311, the deterioration degree determining apparatus 400 sends the determination command to the on-board unit 500. Accordingly, the on-board unit 500 determines that the on-board unit 500 receives the determination command at step S11, and executes the processes of steps S12 to S20A or S20B.

According to the third embodiment, the deterioration degree determining apparatus 400 sends the determination command to the on-board units 500 when the deterioration degree determining apparatus 400 determines that the vehicles 10 are in the traffic jams based on the position data received from the on-board units 500. Therefore, it becomes possible to determine the deterioration degrees of the batteries 11 of the vehicles 10 while the vehicles 10 are being used in a case where it is not possible to predict continuous traffic jams on the vehicles 10.

The deterioration degree determining apparatus 400 receives the probe data including the traffic information from a lot of the vehicles 10, and determines existence or non-existence of the traffic jams. Therefore, the deterioration degree determining apparatus 400 predicts stop times of the vehicles 10. Thus, it becomes possible to determine the deterioration degrees of the batteries 11 of the vehicles 10 in a state where the vehicles 10 are surely in the traffic jams.

According to the third embodiment, it is possible to determine the deterioration degrees of the batteries 11 while the vehicles 10 are being used in a similar manner to the first embodiment. Thus, it is possible to provide the deterioration degree determining apparatus 400 and the on-board unit 500 that are very convenient. Accordingly, it is possible to improve the reliabilities of the vehicles 10 and to determine the deterioration degrees of the batteries 11 of the vehicles 10 in a state where the vehicles 10 are surely in the traffic jams.

While the vehicle 10 is in the traffic jam, the generating capacity of the alternator 12 is almost constant, and influences to the user of the vehicle 10 is relatively small even if the part of the functions of the non-driving series electric component 13 is restricted, compared with the driving state of the vehicle 10. Thus, it is possible to provide the deterioration degree determining apparatus 400 and the on-board unit 500 that are very convenient.

In the third embodiment, when the deterioration degree determining apparatus 400 as the remote monitoring center determines that the vehicles 10 are in the traffic jams, the on-board units 500 determine whether the vehicles 10 are in the idling states or not (step S12), and determine whether the idling states continues or not if the vehicles are in the idling states, respectively. And then the on-board units 500 obtain the deterioration degrees of the batteries 11, respectively.

However, the on-board units 500 may execute obtaining processes of the deterioration degrees by omitting the processes of steps S12 to S14, S15B and S17, in a case where the deterioration degree determining apparatus 400 determines that the vehicles 10 are in the traffic jams, for example.

The descriptions of a deterioration degree determining apparatus of exemplary embodiments have been provided heretofore. The present invention is not limited to these embodiments, but various variations and modifications may be made without departing from the scope of the present invention.

## Claims

1. A deterioration degree determining system (100, 200) configured to determine a deterioration degree of a battery (11) of a vehicle (10), the deterioration degree determining system (100, 200) comprising:
a relay (21, 22, 23, 24) which is inserted into electric power pathways (25) of the vehicle (10);
an electric power pathway controller (360) which is mounted on the vehicle (10) and is configured to control electric power pathways (25), by turning on/off the relay (21, 22, 23, 24);
a communication part (120, 220) which is mounted on the vehicle (10) and is configured to perform data communications with a remote monitoring center external to the vehicle (10), the remote monitoring center monitoring the deterioration degree of the battery (11) of the vehicle (10) and having a database (160) for determining deterioration degree;
an electric component activating part (130, 350) which is located in the remote monitoring center and is configured to activate, via the communication part (120, 220), a non-driving series electric component (13) of the vehicle (10) by using electric power of the battery (11);
a charge characteristic value obtaining part (140, 370) which is located in the remote monitoring center and is configured to obtain, via the communication part (120, 220), a charge characteristic value of the battery (11) during a period of time in which a charge state of the battery (11) is increased to a designated degree by charging the battery (11) after the battery (11) is discharged for a designated period of time by causing the electric component activating part (130, 350) to activate the non-driving series electric component (13), the battery (11) being charged by electric power generated by an electric generator (12) of the vehicle (10); and
a deterioration degree determining part (150, 380) which is located in the remote monitoring center and is configured to determine the deterioration degree of the battery (11) by using the database (160) based on the charge characteristic value obtained by the charge characteristic value obtaining part (140, 370);
wherein an electric power pathway controller (360) is configured to control electric power pathways among the battery (11), the electric generator (12), the non-driving series electric component (13) and a driving series electric component (14), and
wherein the electric power pathway controller (360) is configured to shut off electric power from the electric generator (12) to the battery (11) and the non-driving series electric component (13) and to supply the electric power generated by the electric generator (12) to a driving series electric component (14) while the battery (11) is being discharged by supplying the electric power to the non-driving series electric component (13) which is being activated by the electric component activating part (130, 350).

2. The deterioration degree determining system (100, 200) as claimed in claim 1,
wherein the electric power pathway controller (360) shuts off electric power from the electric generator (12) to the non-driving series electric component (13) while the battery (11) is being charged by the electric power generated by the electric generator (12) after discharging the battery (11) by supplying the electric power from the battery (11) to the non-driving series electric component (13) which is activated by the electric component activating part (130, 350).

3. The deterioration degree determining system (100, 200) as claimed in claim 1,
wherein electric power supply from the electric generator (12) to the non-driving series electric component (13) is restricted while the battery (11) is being charged by the electric power of the electric generator (12) after discharging the battery (11) by supplying the electric power from the battery (11) to the non-driving series electric component (13) which is activated by the electric component activating part (130, 350).

4. The deterioration degree determining system (100, 200) as claimed in claim 1, further comprising:
an idling state determining part (230, 320) which is mounted on the vehicle (10) and is configured to determine whether the vehicle (10) is in an idling state or not,
wherein the electric power pathway controller supplies a part of the electric power generated by the electric generator (12) to a driving series electric component when a determination result of the idling state determining part (230, 320) shifts from the idling state to a non-idling state.

5. The deterioration degree determining system (100, 200) as claimed in claim 1, further comprising:
an idling state determining part (230, 320) which is mounted on the vehicle (10) and is configured to determine whether the vehicle (10) is in an idling state or not, and
a continuation determining part (250, 340) configured to determine whether a stop state of the vehicle continues or not,
wherein the deterioration degree determining part (150, 380) determines the deterioration degree of the battery (11) in a case where the idling state determining part (230, 320) determines that the vehicle is in the idling state, and the continuation determining part (250, 340) determines that the stop state continues.

6. The deterioration degree determining system (100, 200) as claimed in claim 5, further comprising:
a traffic information obtaining part (240, 330, 401) which is mounted on the vehicle (10) and is configured to obtain a traffic information,
wherein the continuation determining part determines whether the stop state continues or not based on the traffic information obtained by the traffic information obtaining part (240, 330, 401), and
wherein the deterioration degree determining part (150, 380) determines the deterioration degree of the battery (11) in a case where the continuation determining part determines that the stop state continues based on the traffic information.

7. The deterioration degree determining system (100, 200) as claimed in claim 1,
wherein the deterioration degree determining part (150, 380) determines the deterioration degree of the battery (11) when the deterioration degree determining part (150, 380) receives a determination command from the remote monitoring center via the communication part (120, 220).

8. The deterioration degree determining system (100, 200) as claimed in claim 7, further comprising:
a position data obtaining part (501) which is mounted on the vehicle (10) and is configured to obtain a position data of the vehicle (10),
wherein the position data obtained by the position data obtaining part (501) is sent to the remote monitoring center via the communication part (120, 220),
wherein the remote monitoring center determines whether the vehicle (10) is in a traffic jam or not based on the position data when the remote monitoring center receives the position data, and sends the determination command to the vehicle (10) which is in the traffic jam, and
wherein the deterioration degree determining part (150, 380) determines the deterioration degree of the battery (11) when the deterioration degree determining part (150, 380) receives the determination command from the remote monitoring center via the communication part (120, 220).

## Patentansprüche

1. Verschlechterungsgrad-Bestimmungssystem (100, 200), das dazu eingerichtet ist, einen Verschlechterungsgrad einer Batterie (11) eines Fahrzeugs (10) zu bestimmen, wobei das Verschlechterungsgrad-Bestimmungssystem (100, 200) umfasst:
ein Relais (21, 22, 23, 24), das in elektrische Energiepfade (25) des Fahrzeugs (10) eingefügt wird;
einen elektrischen Energiepfadcontroller (360), der an dem Fahrzeug (10) befestigt ist und dazu eingerichtet ist, die elektrischen Energiepfade (25) durch An/Aus-Schalten des Relais (21, 22, 23, 24) zu steuern;
ein Kommunikationsabschnitt (120, 220), der an dem Fahrzeug (10) befestigt ist und dazu eingerichtet ist, Datenkommunikationen mit einer Fernüberwachungsstelle außerhalb des Fahrzeugs (10) durchzuführen, wobei die Fernüberwachungsstelle den Verschlechterungsgrad der Batterie (11) des Fahrzeugs (10) überwacht und eine Datenbank (160) zum Bestimmen des Verschlechterungsgrads hat;
einen Elektrokomponenten-Aktivierungsabschnitt (130, 350), der sich in der Fernüberwachungsstelle befindet und dazu eingerichtet ist, über den Kommunikationsabschnitt (120, 220) eine nicht-antreibende elektrische Serienkomponente (13) des Fahrzeugs (10) unter Verwendung von elektrischer Energie der Batterie (11) zu aktivieren;
einen Abschnitt zum Erlangen des Ladekennwerts (140, 370), der sich in der Fernüberwachungsstelle befindet und dazu eingerichtet ist, über den Kommunikationsabschnitt (120, 220) einen Ladekennwert der Batterie (11) während einer Zeitperiode zu erlangen, in der ein Ladezustand der Batterie (11) zu einem festgelegten Grad durch Laden der Batterie (11) zugenommen hat, nachdem die Batterie (11) für eine festgelegte Zeitdauer entladen wurde, indem der Elektrokomponenten-Aktivierungsabschnitt (130, 350) das Aktivieren der nicht-antreibenden elektrischen Serienkomponente (13) bewirkt, wobei die Batterie (11) durch elektrische Energie geladen wird, die durch einen elektrischen Generator (12) des Fahrzeugs (10) erzeugt wird; und
einen Verschlechterungsgrad-Bestimmungsabschnitt (150, 380), der sich in der Fernüberwachungsstelle befindet und dazu eingerichtet ist, den Verschlechterungsgrad der Batterie (11) unter Verwendung der Datenbank (160) basierend auf dem Ladekennwert zu bestimmen, der durch den Abschnitt zum Erlangen des Ladekennwerts (140, 370) erlangt wurde;
wobei ein elektrischer Energiepfadcontroller (360) dazu eingerichtet ist, elektrische Energiepfade zwischen der Batterie (11), dem elektrischen Generator (12), der nicht-antreibenden elektrischen Serienkomponente (13) und einer antreibenden elektrischen Serienkomponente (14) zu steuern, und
wobei der elektrische Energiepfadcontroller (360) dazu eingerichtet ist, die elektrische Energie von dem elektrischen Generator (12) zu der Batterie (11) und der nicht-antreibenden elektrischen Serienkomponente (13) abzuschalten und die durch den elektrischen Generator (12) erzeugte elektrische Energie zu einer antreibenden elektrischen Serienkomponente (14) zuzuführen, während die Batterie (11) durch Zuführen der elektrischen Energie an die nicht-antreibende elektrische Serienkomponente (13) entladen wird, die durch den Elektrokomponenten-Aktivierungsabschnitt (130, 350) aktiviert wird.

2. Verschlechterungsgrad-Bestimmungssystem (100, 200) nach Anspruch 1,
wobei der elektrische Energiepfadcontroller (360) die elektrische Energie von dem elektrischen Generator (12) zu der nicht-antreibenden elektrischen Serienkomponente (13) abschaltet, während die Batterie (11) durch die elektrische Energie geladen wird, die durch den elektrischen Generator (12) erzeugt wird, nachdem die Batterie (11) durch Zuführen der elektrischen Energie von der Batterie (11) zu der nicht-antreibenden elektrischen Serienkomponente (13) entladen wurde, die durch den Elektrokomponenten-Aktivierungsabschnitt (130, 350) aktiviert wird.

3. Verschlechterungsgrad-Bestimmungssystem (100, 200) nach Anspruch 1,
wobei die elektrische Energiezufuhr von dem elektrischen Generator (12) zu der nicht-antreibenden elektrischen Serienkomponente (13) beschränkt ist, während die Batterie (11) durch die elektrische Energie des elektrischen Generators (12) geladen wird, nachdem die Batterie (11) durch Zuführen der elektrischen Energie von der Batterie (11) zu der nicht-antreibenden elektrischen Serienkomponente (13) entladen wurde, die durch den Elektrokomponenten-Aktivierungsabschnitt (130, 350) aktiviert wird.

4. Verschlechterungsgrad-Bestimmungssystem (100, 200) nach Anspruch 1, umfasst des Weiteren:
einen Leerlaufbestimmungsabschnitt (230, 320), der an dem Fahrzeug (10) befestigt ist und dazu eingerichtet ist zu bestimmen, ob das Fahrzeug (10) sich in einem Leerlauf befindet oder nicht,
wobei der elektrische Energiepfadcontroller einen Teil der durch den elektrischen Generator (12) erzeugten Energie an eine antreibende elektrische Serienkomponente zuführt, wenn ein Bestimmungsergebnis des Leerlaufbestimmungsabschnitts (230, 320) sich von dem Leerlauf zu einem Nicht-Leerlauf verschiebt.

5. Verschlechterungsgrad-Bestimmungssystem (100, 200) nach Anspruch 1, umfasst des Weiteren:
einen Leerlaufbestimmungsabschnitt (230, 320), der an dem Fahrzeug (10) befestigt ist und dazu eingerichtet ist zu bestimmen, ob das Fahrzeug (10) sich in einem Leerlauf befindet oder nicht, und
einen Fortsetzungsbestimmungsabschnitt (250, 340), der dazu eingerichtet ist zu bestimmen, ob ein Stoppzustand des Fahrzeugs fortgesetzt wird oder nicht,
wobei der Verschlechterungsgrad-Bestimmungsabschnitt (150, 380) den Verschlechterungsgrad der Batterie (11) in einem Fall bestimmt, in dem der Leerlaufbestimmungsabschnitt (230, 320) bestimmt, dass sich das Fahrzeug in dem Leerlauf befindet und der Fortsetzungsbestimmungsabschnitt (250, 340) bestimmt, dass der Stoppzustand fortgesetzt wird.

6. Verschlechterungsgrad-Bestimmungssystem (100, 200) nach Anspruch 5, umfasst des Weiteren:
einen Verkehrsinformationserlangungsabschnitt (240, 330, 401), der an dem Fahrzeug (10) befestigt ist und dazu eingerichtet ist eine Verkehrsinformation zu erlangen,
wobei der Fortsetzungsbestimmungsabschnitt basierend auf der Verkehrsinformation bestimmt, die durch den Verkehrsinformationserlangungsabschnitt (240, 330, 401) erlangt wird, ob der Stoppzustand fortgesetzt wird oder nicht, und
wobei der Verschlechterungsgrad-Bestimmungsabschnitt (150, 380) den Verschlechterungsgrad der Batterie (11) in einem Fall bestimmt, in dem der Fortsetzungsbestimmungsabschnitt basierend auf der Verkehrsinformation bestimmt, dass der Stoppzustand fortgesetzt wird.

7. Verschlechterungsgrad-Bestimmungssystem (100, 200) nach Anspruch 1,
wobei der Verschlechterungsgrad-Bestimmungsabschnitt (150, 380) den Verschlechterungsgrad der Batterie (11) bestimmt, wenn der Verschlechterungsgrad-Bestimmungsabschnitt (150, 380) eine Bestimmungsanweisung von der Fernüberwachungsstelle über den Kommunikationsabschnitt (120, 220) empfängt.

8. Verschlechterungsgrad-Bestimmungssystem (100, 200) nach Anspruch 7, umfasst des Weiteren:
einen Positionsdatenerlangungsabschnitt (501), der an dem Fahrzeug (10) befestigt ist und dazu eingerichtet ist, Positionsdaten des Fahrzeugs (10) zu erlangen,
wobei die durch den Positionsdatenerlangungsabschnitt (501) erlangten Positionsdaten an die Fernüberwachungsstelle über den Kommunikationsabschnitt (120, 220) gesendet werden,
wobei die Fernüberwachungsstelle basierend auf den Positionsdaten bestimmt, ob das Fahrzeug (10) sich in einem Stau befindet oder nicht, wenn die Fernüberwachungsstelle die Positionsdaten empfängt, und eine Bestimmungsanweisung an das Fahrzeug (10) sendet, das sich in dem Stau befindet, und
wobei der Verschlechterungsgrad-Bestimmungsabschnitt (150, 380) den Verschlechterungsgrad der Batterie (11) bestimmt, wenn der Verschlechterungsgrad-Bestimmungsabschnitt (150, 380) die Bestimmungsanweisung von der Fernüberwachungsstelle über den Kommunikationsabschnitt (120, 220) empfängt.

## Revendications

1. Système de détermination de degré de détérioration (100, 200) configuré pour déterminer un degré de détérioration d'une batterie (11) d'un véhicule (10), le système de détermination de degré de détérioration (100, 200) comprenant :
un relais (21, 22, 23, 24) qui est inséré dans des voies de courant électrique (25) du véhicule (10) ;
un contrôleur de voie de courant électrique (360) qui est monté sur le véhicule (10) et configuré pour commander des voies de courant électrique (25), en ouvrant/fermant le relais (21, 22, 23, 24) ;
une partie de communication (120, 220) qui est montée sur le véhicule (10) et configurée pour réaliser des communications de données avec un centre de surveillance distant externe au véhicule (10), le centre de surveillance distant surveillant le degré de détérioration de la batterie (11) du véhicule (10) et ayant une base de données (160) pour déterminer le degré de détérioration ;
une partie d'activation de composant électrique (130, 350) qui est située dans le centre de surveillance distant et configurée pour activer, par l'intermédiaire de la partie de communication (120, 220), un composant électrique de série non-moteur (13) du véhicule (10) à l'aide d'un courant électrique de la batterie (11) ;
une partie d'obtention de valeur de caractéristique de charge (140, 370) qui est située dans le centre de surveillance distant et configurée pour obtenir, par l'intermédiaire de la partie de communication (120, 220), une valeur de caractéristique de charge de la batterie (11) pendant une période dans laquelle un état de charge de la batterie (11) est augmenté à un degré indiqué par chargement de la batterie (11) après que la batterie (11) ait été déchargée pendant une période indiquée en amenant la partie d'activation de composant électrique (130, 350) à activer le composant électrique de série non-moteur (13), la batterie (11) étant chargée par un courant électrique généré par un générateur électrique (12) du véhicule (10) ; et
une partie de détermination de degré de détérioration (150, 380) qui est située dans le centre de surveillance distant et configurée pour déterminer le degré de détérioration de la batterie (11) à l'aide de la base de données (160) sur la base de la valeur de caractéristique de charge obtenue par la partie d'obtention de valeur de caractéristique de charge (140, 370) ;
dans lequel un contrôleur de voie de courant électrique (360) est configuré pour commander des voies de courant électrique parmi la batterie (11), le générateur électrique (12), le composant électrique de série non-moteur (13) et un composant électrique de série moteur (14), et
dans lequel le contrôleur de voie de courant électrique (360) est configuré pour fermer un courant électrique du générateur électrique (12) à la batterie (11) et au composant électrique de série non-moteur (13) et pour fournir le courant électrique généré par le générateur électrique (12) à un composant électrique de série moteur (14) tandis que la batterie (11) est en train de se décharger en fournissant le courant électrique au composant électrique de série non-moteur (13) qui est activé par la partie d'activation de composant électrique (130, 350).

2. Système de détermination de degré de détérioration (100, 200) selon la revendication 1,
dans lequel le contrôleur de voie de courant électrique (360) ferme le courant électrique du générateur électrique (12) au composant électrique de série non-moteur (13) tandis que la batterie (11) est en cours de chargement par le courant électrique généré par le générateur électrique (12) après déchargement de la batterie (11) en fournissant le courant électrique de la batterie (11) au composant électrique de série non-moteur (13) qui est activé par la partie d'activation de composant électrique (130, 350).

3. Système de détermination de degré de détérioration (100, 200) selon la revendication 1,
dans lequel le courant électrique du générateur électrique (12) au composant électrique de série non-moteur (13) est restreint tandis que la batterie (11) est en cours de chargement par le courant électrique du générateur électrique (12) après déchargement de la batterie (11) en fournissant le courant électrique de la batterie (11) au composant électrique de série non-moteur (13) qui est activé par la partie d'activation de composant électrique (130, 350).

4. Système de détermination de degré de détérioration (100, 200) selon la revendication 1, comprenant en outre :
une partie de détermination d'état inactif (230, 320) qui est montée sur le véhicule (10) et configurée pour déterminer si le véhicule (10) est dans un état inactif ou non,
dans lequel le contrôleur de voie de courant électrique fournit une partie du courant électrique généré par le générateur électrique (12) à un composant électrique de série moteur lorsqu'un résultat de détermination de la partie de détermination d'état inactif (230, 320) commute de l'état inactif à un état non inactif.

5. Système de détermination de degré de détérioration (100, 200) selon la revendication 1, comprenant en outre :
une partie de détermination d'état inactif (230, 320) qui est montée sur le véhicule (10) et configurée pour déterminer si le véhicule (10) est dans un état inactif ou non, et
une partie de détermination de continuation (250, 340) configurée pour déterminer si un état d'arrêt du véhicule continue ou non,
dans lequel la partie de détermination de degré de détérioration (150, 380) détermine le degré de détérioration de la batterie (11) dans un cas où la partie de détermination d'état inactif (230, 320) détermine que le véhicule est dans l'état inactif et la partie de détermination de continuation (250, 340) détermine que l'état d'arrêt continue.

6. Système de détermination de degré de détérioration (100, 200) selon la revendication 5, comprenant en outre :
une partie d'obtention d'informations de circulation (240, 330, 401) qui est montée sur le véhicule (10) et configurée pour obtenir des informations de circulation,
dans lequel la partie de détermination de continuation détermine si l'état d'arrêt continue ou non sur la base des informations de circulation obtenues par la partie d'obtention d'informations de circulation (240, 330, 401), et
dans lequel la partie de détermination de degré de détérioration de la batterie (150, 380) détermine le degré de détérioration de la batterie (11) dans un cas où la partie de détermination de continuation détermine que l'état d'arrêt continue sur la base des informations de circulation.

7. Système de détermination de degré de détérioration (100, 200) selon la revendication 1,
dans lequel la partie de détermination de degré de détérioration (150, 380) détermine le degré de détérioration de la batterie (11) lorsque la partie de détermination de degré de détérioration (150, 380) reçoit une commande de détermination provenant du centre de surveillance distant par l'intermédiaire de la partie de communication (120, 220).

8. Système de détermination de degré de détérioration (100, 200) selon la revendication 7, comprenant en outre
une partie d'obtention de données de position (501) qui est montée sur le véhicule (10) et configurée pour obtenir des données de position du véhicule (10),
dans lequel les données de position obtenues par la partie d'obtention de données de position (501) sont envoyées au centre de surveillance distant par l'intermédiaire de la partie de communication (120, 220),
dans lequel le centre de surveillance distant détermine si le véhicule (10) se trouve dans un embouteillage ou non sur la base des données de position lorsque le centre de surveillance distant reçoit les données de position, et envoie la commande de détermination au véhicule (10) qui se trouve dans l'embouteillage, et
dans lequel la partie de détermination de degré de détérioration (150, 380) détermine le degré de détérioration de la batterie (11) lorsque la partie de détermination de degré de détérioration (150, 380) reçoit la commande de détermination en provenance du centre de surveillance distant par l'intermédiaire de la partie de communication (120, 220).
